# FASCICULE DE BREVET EUROPEEN

(11) **EP 2 250 298 B1**
(45) Date de publication et mention de la délivrance du brevet: **13.07.2011**
(21) Numéro de dépôt: 09718643.1
(22) Date de dépôt: 20.02.2009
(51) Int. Cl.: C23C 16/18, C23C 16/24, C23C 16/32, C23C 16/44

(54) **PROCEDE ET SYSTEME DE DEPOT D'UN METAL OU METALLOÏDE SUR DES NANOTUBES DE CARBONE**
VERFAHREN UND SYSTEM ZUR ABLAGERUNG EINES METALLS ODER METALLOIDS AUF KOHLENSTOFFNANORÖHRCHEN
METHOD AND SYSTEM FOR DEPOSITING A METAL OR METALLOID ON CARBON NANOTUBES

(30) Priorité: 11.03.2008 FR 0851581
(43) Date de publication de la demande: 17.11.2010
(73) Titulaire: ARKEMA FRANCE, 92700 Colombes (FR)
(72) Inventeur: BORDERE, Serge, F-64110 Jurancon (FR); COCHARD, Daniel, F-64300 Argagnon (FR); DUTILH, Eric, F-40600 Biscarosse (FR); GAILLARD, Patrice, F-64370 Hagetaubin (FR); VOIRY, Damien, F-37300 Joue-les Tours (FR)
(74) Mandataire: Bonnel, Claudine
(86) Numéro de dépôt international: PCT/FR2009/050274
(87) Numéro de publication internationale: WO 2009/112738

(56) Documents cités:
- WO-A-2007/088292
- CN-A- 101 015 783
- KR-B1- 100 751 557
- SERP P ET AL: "CONTROLLED-GROWTH OF PLATINUM NANOPARTICLES ON CARBON NANOTUBES OR NANOSPHERES B MOCVD IN FLUIDIZED BED REACTOR" JOURNAL DE PHYSIQUE IV, EDITIONS DE PHYSIQUE. LES ULIS CEDEX, FR, vol. 12, no. 4, 1 juin 2002 (2002-06-01), pages PR4-29, XP009062695 ISSN: 1155-4339
- WANG Y H ET AL: "Microstructure and thermal characteristic of Si-coated multi-walled carbon nanotubes" NANOTECHNOLOGY, IOP, BRISTOL, GB, vol. 17, no. 15, 14 août 2006 (2006-08-14), pages 3817-3821, XP020103951 ISSN: 0957-4484 cité dans la demande
- SHAJAHAN MD ET AL: "Effect of chemical vapor deposition energy sources on the structure of SiC prepared by carbon nanotubes-confined reaction" JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 21, no. 3, 1 mai 2003 (2003-05-01), pages 1149-1156, XP012009891 ISSN: 0734-211X cité dans la demande

## Description

L'invention concerne un procédé et un système industriel de dépôt d'un métal ou métalloïde, sur des nanotubes de carbone (NTC)

Les nanotubes de carbone sont des matériaux de renforcement très prometteurs pour fabriquer des matrices métalliques (fabrication d'alliage métal-NTC) ou des céramiques composites. Cependant, des tests ont montré dans de telles applications que les propriétés mécaniques des NTC sont inférieures à celles attendues. Plusieurs raisons expliquant ces résultats ont été trouvées.

D'une part les NTC ont tendance à interagir avec la matrice métallique lorsqu'ils sont placés dans une atmosphère oxydante ce qui dégrade leur structure et leurs propriétés et diminue leur propriété de renfort. De plus, la liaison inter faciale entre les NTC et la matrice métallique est faible, ce qui augmente les risques de décohésion.

En outre, lors de la préparation d'un alliage métal-NTC, les températures atteintes engendrent une réaction entre les nanotubes de carbone, qui produit des carbures. Ceci altère la microstructure et les propriétés inter faciales des nanotubes.

Pour résoudre ce problème, plusieurs approches ont été proposées:

### 1- Une première approche proposée consiste à déposer une couche de matériau inorganique tel qu'un métal sur les parois des nanotubes de carbone.

Il existe pour ce faire plusieurs méthodes de dépôt :

### a) - la voie humide,

Cette méthode est simple et réalisable à basse température. Cependant il est difficile de rincer complètement les résidus des produits et de contrôler précisément la taille des particules déposées à la surface des NTC. De plus, la forte tension de surface et la forte hydrophobicité des NTC les rendent difficiles à mouiller. Enfin, les particules peuvent remplir les cavités des NTC de manière non maîtrisable.

### b) - la voie vapeur (Physical Vapor Deposition PVD ou Metal Organique Chemical Vapor Deposition CVD).

La voie vapeur améliore la meilleure maîtrise du dépôt car on peut jouer sur les débits et le temps d'exposition. La croissance des particules à la surface des NTC peut être ainsi précisément contrôlée. Néanmoins l'absence de molécules réactives appropriées limite l'application de cette méthode pour un dépôt métallique.

En outre, les expériences de dépôt réalisées sur des NTC ont montré qu'il était difficile de réussir à parfaitement déposer un film fin et homogène à la surface des NTC. En effet, ces techniques sont applicables à des substrats plans, leur efficacité est réduite pour les nanotubes et a fortiori pour les pelotes de nanotubes.

### c) - la voie solide.

Différents méthodes par voie solides ont été tentées pour améliorer les procédés de dépôt par voie vapeur.

Une méthode pour déposer du dioxyde d'étain en injectant un précurseur SnH4 dans un réacteur chauffé à 550°C et à une pression de 23, 2 Torr soit 3.10-2 bar est décrite dans le document « Controllable fabrication of SnO2-coated multiwalled carbon nanotubes by chemical vapor deposition » de Q. KUANG et al ; Carbon 44(2006), pp.1166-1172. Cette méthode nécessite une purification des NTC par de l'acide nitrique.

Une méthode, décrite par exemple, dans la demande US 2006/0043649 A1 a été développée pour le dépôt de bore. Cette méthode consiste à mélanger de la poudre de MgB₂ aux NTC purifiés par de l'acide fluorhydrique (HF). Une fois mélangé, l'ensemble est recouvert d'une feuille de thallium et placé dans un four à 1100°C et à une pression de 0,5Torr soit 6.10⁻⁴bar.

Une méthode, décrite dans le document intitulé « Carbon Nanotubes Coated with Alumiina as Gate Dielectrics of Field Transistor de L. FU, Z.LIU, et al, Adv. Matter 2006, 18, pp181-185, a été développée pour déposer de l'aluminium. Cette méthode utilise la voie supercritique. Les NTC sont dissouts dans une solution d'éthanol contenant du nitrate d'aluminium nonahydrate. Du CO₂ supercritique est injecté à 35°C. Une solution mixte d'éthanol et de CO₂ se forme et dissout le nitrate d'aluminium nonahydrate. L'ensemble est alors chauffé à 80°C pendant 6 heures.

Pour finir, des expériences de dépôt de cuivre ont été tentées à partir de précurseurs organiques, notamment de l'acétylacétonate de cuivre II. Les NTC sont purifiés par l'acide nitrique puis imprégnés par le précurseur et ensuite placés dans un four à 300°C avec un flux d'hydrogène de 200ml/minute pendant 30minutes. Cette expérience est décrite dans le document intitulé « Préparation of Coper Coated Carbon Nanotubes by Decomposition of Cu(II) acetylacetonate in Hydrogen Atmosphere, G. WENLI, Z. YUE, L. TONGXIANG, J. Mater. Sci.41, 2006, pp.5462-5466.

Ces techniques sont difficilement transposables à une production en continu et nécessite des conditions contraignantes. De plus les NTC doivent être purifiés pour améliorer le rendement de dépôt.

### 2- Une deuxième approche consiste à déposer une couche protectrice de silicium sur les parois des nanotubes au moyen de la technique CVD par la décomposition in-situ de gaz chargé en silicium.

En effet, l'article intitulé "Effect of Chemical Vapor Deposition Energy Sources on the Structure of SiC Prepared by Carbon Nanotubes-Confined Reaction" J.Vac.Sci. Technol. B21(3), May/Juin 2003 publié le 27/05/2003; décrit un procédé pour obtenir des NTC comprenant à la surface du carbure de silicium (SiC) nanostructuré à partir d'un précurseur contenant du silicium tel que le tétraméthylsilane (TMS).

La transformation du tétraméthylsilane est réalisée dans un réacteur de faible capacité en fonctionnement discontinu et se fait à une température supérieure à 1100° et sous une pression de 10mBar.

Ce procédé ne peut pas être exploité dans une fabrication à échelle industrielle du fait des conditions contraignantes qui sont imposées pour la température et la pression.

On pourra se reporter également à l'état de la technique constitué par le document D1 correspondant à la publication SERP P et A1 intitulée « Controlled-growth of platinium nanoparticules on carbon nanotubes or nanosphères B MOCVD in fluidized bed reactor »- Journal de physique IV, editions de physique. Les Ulis Cedex FR, vol 12, n°4, 1 juin 2002 (2002-06-01) pages PR4-29, XP009062695 ISSN: 1155-4339. Il s'agit d'un procédé de dépôt de platine sur des NTC au moyen de la technique de dépôt CVD. Cette publication, décrit plus particulièrement les conditions expérimentales qui permettent de déposer le platine sur des NTC par dépôt CVD en lit fluidisé. Ces conditions imposent une pression faible, inférieure à la pression atmosphérique, et un traitement chimique (à l'acide) des NTC pour permettre l'accrochage du platine sur les NTC. Ce procédé s'applique à la réalisation de supports catalytiques.

Dans le document D2, WO2007/088292 A (Commissariat Energie atomique), c'est un procédé de fabrication d'une électrode pour réacteur électrochimique qui est décrit. Dans ce procédé, le dépôt du catalyseur est réalisé par DLI-MOCVD sur des NTC. Le catalyseur est le platine. Le procédé dans ce cas, consiste en une pulvérisation de platine (voie liquide) sur une couche de diffusion réalisée en carbone poreux constituée par des NTC placés sur un substrat. Les applications possibles sont les mêmes que pour D1.

Dans le document D3, intitulé "Microstructure and Thermal Characteristic of Si Coated Multiwalled Carbon Nanotubes " Y.H Wang, Y.N.Li, J.B Zang, H. Huang, Nanotechnology 17, 2000, pp.3817-3821, un procédé de dépôt de Si sur NTC est décrit. Ce procédé est similaire à la deuxième approche décrite précédemment. Cependant dans ce cas on utilise comme précurseur du silane (SiH4). En outre, le dépôt se fait par cycles successifs de dépôt. Plusieurs cycles de vide et d'injection de gaz sont nécessaires pour permettre un dépôt suffisant. Les températures sont de l'ordre de 550°C et le vide est poussé à 10⁻⁶mbar. Un cycle dure plusieurs heures. Une production en continu n'est pas envisageable avec cette technique. Les NTC nécessitent un traitement thermique (à 550°C).

Il est clair que toutes les méthodes décrites précédemment sont difficilement transposables à une production en continu et par conséquent, aucune ne permet la mise en oeuvre d'une réelle exploitation industrielle. En effet, certaines méthodes imposent des conditions contraignantes en particulier en ce qui concerne la température et la pression et/ou présentent un caractère discontinu ou imposent une purification des NTC (traitement thermique).

Dans tous les cas, aucun procédé décrit ne permet de proposer une solution industrielle réellement exploitable pour le dépôt sur des NTC, de métaux tels que l'étain, l'aluminium, le cuivre ou de métalloïdes c'est-à-dire des semi-conducteurs comme le silicium, le bore, ou le germanium. Le procédé selon l'invention apporte une solution sans qu'il soit nécessaire de traiter les NTC, les NTC pouvant être bruts, et avec des conditions non contraignantes à savoir une température inférieure à 1000°C et une pression qui est la pression atmosphérique.

La présente invention permet de remédier ainsi aux inconvénients des techniques antérieures. La solution proposée est un procédé de dépôt d'un métal ou métalloïde pouvant se mettre sous forme organique, sur des nanotubes de carbone (NTC) dont la mise en oeuvre se fait dans des conditions modérées: une température ne dépassant pas les 1000°C et à pression atmosphérique. Il n'est nullement nécessaire avec le procédé proposé de purifier (traiter) les nanotubes, des NTC bruts peuvent être utilisés. En outre le procédé peut être mis en oeuvre en continu. Il apporte ainsi une solution industrielle à la fabrication de NTC recouverts d'une couche de protection par exemple de Si (silicium), de Ge (germanium) ou de B (bore) ou encore de A1 (aluminium), de Cu (cuivre) ou de Sn (étain) ; améliorant ainsi les propriétés thermiques, conductrices, et mécaniques des matériaux comprenant dans leur composition lesdits nanotubes. Le procédé selon la présente invention a des applications telles que la fabrication de matériaux sous forme de matrice conductrice ou de céramique composite pour l'aéronautique, la métallurgie, l'automobile, les circuits intégrés.

La présente invention a plus particulièrement pour objet, un procédé de dépôt d'un métal ou métalloïde, sur des nanotubes de carbone (NTC), principalement caractérisé en ce qu'il comprend:
- l'homogénéisation d'une poudre de NTC dans un réacteur,
- le dépôt sur cette poudre homogène de NTC dudit métal, choisi parmi l'étain, l'aluminium ou le cuivre, ou dudit métalloïde, choisi parmi le silicium, le bore, le germanium ; au moyen d'une technique de dépôt en phase vapeur opérée à l'intérieur du réacteur à partir d'un précurseur formé d'un alkyle de ce métal ou métalloïde; le dépôt en phase vapeur étant réalisé dans le réacteur à la pression atmosphérique et à une température inférieure à 1000°C, le précurseur étant injecté dans le réacteur, sous forme de gaz.

Le précurseur à l'état liquide est transformé en phase vapeur par chauffage et injecté sous forme de gaz ou transporté au moyen d'un gaz de manière à être injecté sous forme de gaz.

Dans un exemple de réalisation correspondant à une production par lot, une quantité prédéterminée de NTC bruts est introduite à froid dans le réacteur, le gaz est injecté pour former la poudre homogène de NTC par mise en lit fluidisé des NTC, le réacteur est mis en chauffe à une température prédéfinie inférieure à 1000°C, lorsque la température prédéfinie est atteinte, le précurseur est injecté dans le réacteur et se décompose à la surface de NTC, le réacteur comporte une sortie permettant de récupérer les NTC recouverts par le dépôt.

Pour obtenir un fonctionnement industriel en continu, le réacteur utilisé comprend une entrée en continu des NTC bruts et une sortie d'évacuation basse permettant ainsi grâce à la gravité de récupérer les NTC recouverts par le dépôt tout le long du fonctionnement, les NTC en formation restant en suspension dans le réacteur.

Dans le cas du dépôt de silicium (Si) on choisit de préférence comme précurseur du tétraméthylsilane (TMS).

Le gaz servant à l'injection du TMS vapeur peut être de l'hydrogène, il permet ainsi de diluer le TMS et d'éviter la formation de coke.

Le gaz servant à obtenir le balayage pour le lit fluidisé peut être un gaz inerte ou de l'hydrogène.

Le procédé permet de fabriquer du carbure de silicium nanostructuré (SiC) à la surface des NTC.

Le procédé s'applique à la fabrication de matrices métalliques ou de céramiques composites.

Un système de mise en oeuvre du procédé est également décrit comportant un réacteur dans lequel le dépôt en phase vapeur est opéré, ledit réacteur comprenant une entrée pour recevoir des NTC bruts, une entrée pour l'injection d'un gaz, des moyens pour obtenir un lit fluidisé de poudre de NTC sous l'injection du gaz, une entrée pour recevoir le précurseur permettant d'obtenir le dépôt en phase vapeur, une sortie d'évacuation des NTC recouverts du dépôt obtenu par le dépôt en phase vapeur, ledit système comprenant également des moyens de réglage de débit pour l'introduction du précurseur dans le réacteur.

Ces moyens comportent un débitmètre placé sur le circuit du précurseur après transformation en phase vapeur de ce dernier et un débitmètre placé sur le circuit du gaz de transport et dilution du précurseur.

Les NTC peuvent être fournis en quantité dosée à partir d'un récipient de stockage ou en continu à partir d'une conduite de transport.

Le système peut comprendre également, un dispositif pour transformer le précurseur en phase vapeur et un régulateur de débit pour injecter le précurseur sous forme vapeur dans le réacteur à un débit donné avec le gaz permettant de diluer ledit précurseur et diminuer ainsi les surconcentrations de contact (afin d'éviter la formation de coke).

L'invention s'applique à la fabrication de carbure de silicium nanostructuré (SIC) à la surface des NTC.

L'invention s'applique aussi à la fabrication de matrices métalliques ou de céramiques composites.

D'autres particularités et avantages de l'invention apparaîtront clairement à la lecture de la description qui est faite ci-après et qui est donnée à titre d'exemple illustratif et non limitatif et en regard des figures sur lesquelles:
- la figure 1 représente un schéma d'un système de mise en oeuvre de l'invention ;
- la figure 2 représente un graphique illustrant l'évolution du taux de cendre pour un dépôt de Si en phase vapeur sur des nanotubes en fonction du rapport TMS/NTC et celui de NTC bruts,

- La figure 3 représente un graphique illustrant l'évolution de la teneur en silicium et du rendement en fonction du rapport TMS/NTC pour les différents essais,
- la figure 4 représente le spectre aux rayons X de l'échantillon 401,
- La figure 5 représente le spectre aux rayons X de l'échantillon 402,
- la figure 6 représente le spectre aux rayons X de l'échantillon de référence de NTC bruts,
- la figure 7 représente le spectre aux rayons X d'un échantillon de SiC,
- La figure 8 représente la courbe de comportement vis-à-vis de la température et sous air des NTC bruts,
- la figure 9 représente la courbe de comportement vis-à-vis de la température et sous air des NTC recouverts de silicium,
- La figure 10 représente la courbe de comportement vis-à-vis de la température et sous air d'un échantillon de SiC.

La description qui va suivre concerne un exemple de mise en oeuvre pratique du procédé dans le cas d'un dépôt de silicium (Si) par CVD en utilisant comme précurseur du tétraméthylsilane (TMS). Le dépôt de Si sur des NTC permet d'obtenir du SiC nanostructuré à la surface des NTC.

Le TMS est injecté dans un réacteur 10 où il se décompose et du silicium issu de cette décomposition se dépose sur les nanotubes.

Le réacteur est un réacteur à lit fluidisé de 5 cm de diamètre (2 pouces).

Le TMS est introduit dans une capacité 20 à double enveloppe inertée par inspiration sous vide directement dans une bouteille 21 de TMS. Le TMS est chauffé au moyen d'un bain thermostaté 23 à une température comprise entre 50 et 65°C pour une pression relative de 1,6 Bar de manière à pouvoir être introduit sous forme vapeur dans le réacteur et à pouvoir réguler son débit. La poudre de NTC est placée dans le réacteur 10 à lit fluidisé par une entrée 11 placée sur le haut du réacteur 10. L'entrée 11 peut être alimentée par un récipient de stockage ou par une conduite de transport 40.

En pratique, la température du bain thermostaté est de 62°C, et la capacité 20 est une capacité inox (1L).

Le réacteur 10 est mis en chauffe à 850°C sous balayage d'un gaz injecté par une entrée 13 située sous le réacteur 10. Dans une première phase correspondant à la période de chauffe du réacteur, le gaz est un gaz inerte par exemple de l'azote (N2), puis dans une deuxième phase, lorsque la température interne du réacteur atteint les 850°C, l'arrivée d'azote est fermée, le gaz injecté par l'entrée 13 est alors de l'hydrogène.

Lorsque le réacteur 10 a atteint la température désirée, le TMS vapeur est injecté par une entrée 12 dans ledit réacteur 10 à un débit contrôlé au moyen d'un débitmètre massique 30. Le TMS vapeur est entraîné dans le réacteur 10 par un léger courant d'hydrogène empruntant le même circuit 31 que le TMS. Le débit de l'hydrogène est contrôlé par le débitmètre 32.

L'hydrogène est mélangé au TMS afin de le diluer le TMS et d'empêcher les surconcentrations de contact évitant ainsi le dépôt de carbone.

Le réacteur est maintenu à une température de 850° durant tout le temps de l'injection du TMS.

Le TMS sous forme de vapeur chauffé se décompose et du silicium se dépose sur la poudre de NTC. Les sous-produits de la réaction sont envoyés vers la torche 11 en sortie du réacteur 10.

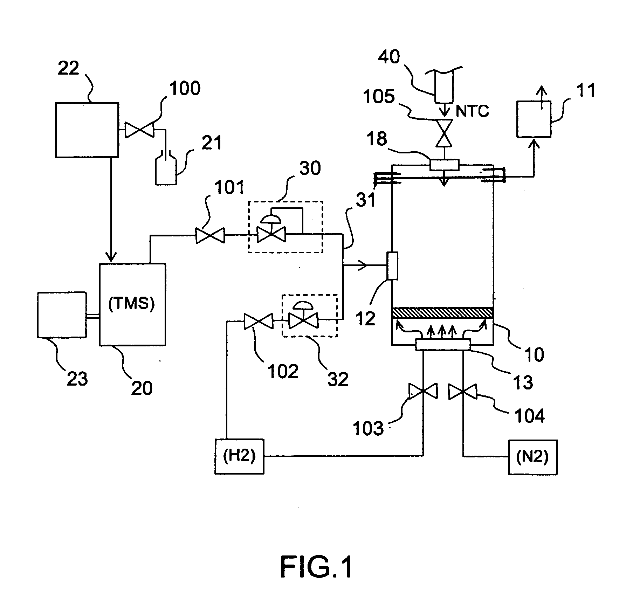

Seules quelques vannes ont été représentées à titre d'exemple sur les circuits reliant les différents éléments du système représenté sur la figure 1. Ces vannes portent les références 100 à 105 sur cette figure et peuvent être commandées de façon classique, manuellement ou de façon automatique par un automate programmé à cet effet (automate non représenté). Ce même automate peut également être programmé pour commander de façon automatique, les dispositifs de réglage du débit du TMS et de l'hydrogène.

Différents essais ont été menés dans les conditions opératoires résumées dans le tableau ci-dessous afin de montrer l'efficacité du procédé.

Pour 20g de NTC injecté dans le réacteur (hauteur du lit de NTC en cm):

| | Essai 1 (Echantillon 395) | Essai 2 (Echantillon 397) | Essai 3 (Echantillon 401) | Essai 4 (Echantillon 402) |
|---|---|---|---|---|
| Masse de NTC récupéré (g) | 22 | 22,1 | 20.4 | 21.7 |
| Hauteur du lit (cm) | 9,3 | 9,4 | 8.6 | 9.3 |
| | | | | |
| Masse de TMS injecté (g) | 43,9 | 19,6 | 19.3 | 47.5 |
| Masse de silicium injecté (g) | 14 | 6,2 | 6.1 | 15.2 |
| | | | | |
| Débit en TMS (1/h) | 6,8 | 3.4 | 6.8 | 6.8 |
| Débit en hydrogène (1/h) | 200 | 200 | 200 | 200 |
| Débit en hydrogène pour injection (1/h) | 12 | 12 | 12 | 12 |
| | | | | |
| Température du Réacteur (°C) | 850 | 850 | 850 | 850 |
| Température du bain (°C) | 62,7 | 62,7 | 62.7 | 62.7 |

On peut voir sur ce tableau que lorsque l'on injecte une masse de 43,9g de TMS [(CH₃)₄-Si], on injecte 14g de Si, pour 19,3g de TMS, on injecte 6,1g de Si et pour 47,5g de TMS on injecte 15,2g de Si.

On constate que pour les différents essais réalisés la masse de NTC récupérée est supérieure à la masse des NTC injectés. Il s'est produit un dépôt de Si sur les NTC issus de la décomposition de TMS. Ce dépôt évolue avec la masse de TMS injectée et son débit.

Parmi toutes les molécules organiques, le TMS a été choisi car il est le meilleur compromis entre la volatilité et la longueur des chaînes carbonées des ligands.

Dans le cas où le précurseur utilisé serait silane ou du disilane, la décomposition peut se faire à une température de 400°C, pour le TMS la décomposition se fait à 650°C.

### La mise en évidence du silicium dans le dépôt a été confirmée par différentes mesures :

### 1) Des mesures du taux de cendre.

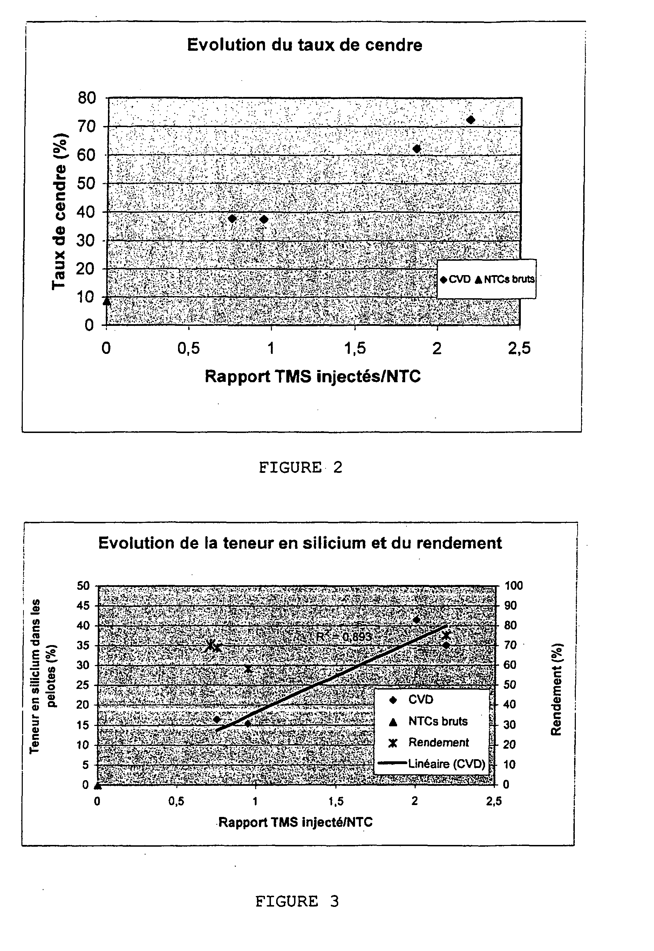

Ces mesures permettent comme on va le voir sur les figures 2 et 3 de montrer que l'on obtient du carbure de silicium et que par conséquent du dépôt de silicium a bien eu lieu.

La figure 2 montre le taux de cendre en fonction du rapport de TMS/NTC pour un échantillon de NTC brut comparativement à l'évolution de ce taux pour un échantillon sur lequel on a procédé à un dépôt par CVD de Si selon l'invention.

La figure 3 montre l'évolution de la teneur en Si et les rendements obtenus suivant les différents essais:
échantillon 397, TMS/NTC: 0,75 ; taux de cendre: 37, 81
échantillon 395, TMS/NTC: 0,94 ; taux de cendre: 37, 41
échantillon 402, TMS/NTC: 1,86 ; taux de cendre: 62,26
échantillon 401, TMS/NTC: 2,18 ; taux de cendre: 72,4.

Le taux de Si augmente de 15% à plus de 35% lorsque les quantités de TMS sont doublées.

### Les Conditions de mesures ont été les suivantes :

Les taux de cendre réalisés à 800°C pendant 1heure.

Pour l'échantillon de nanotubes bruts pris comme référence sur la figure 2, le taux de cendre vaut 8,7%

On constate qu'avec le procédé de dépôt employé, les taux de cendre varient quasi linéairement avec l'évolution du rapport TMS injecté/NTC. On obtient un taux de cendre supérieur à 70% dans le cas du rapport 2,19 c'est-à-dire pour l'échantillon 401. La présence de SiC est confirmée.

### 2) L'analyse aux rayons X :

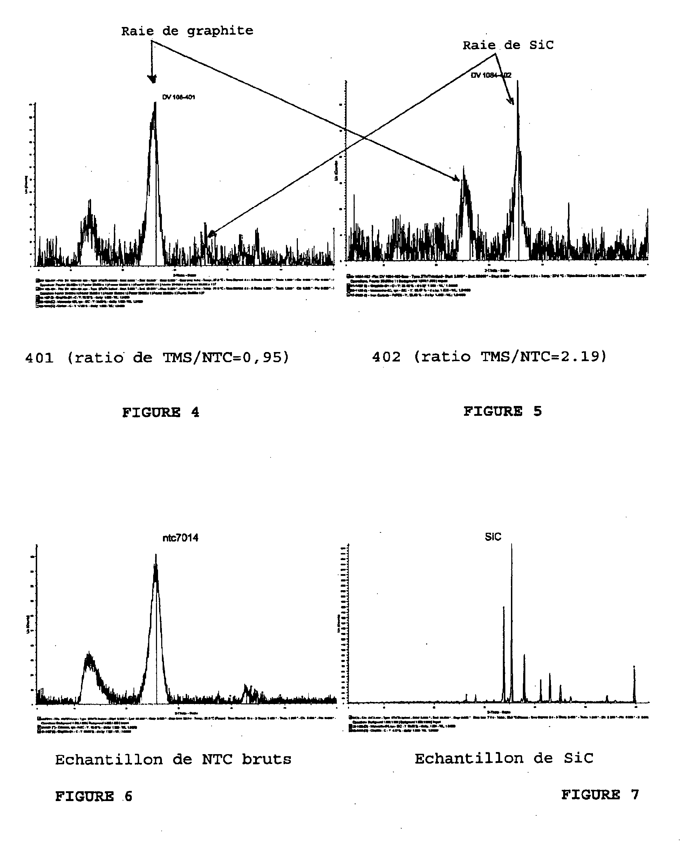

Les différents spectres obtenus sont représentés sur les figures 4 à 7.

Tous les échantillons issus des essais 1 à 4 ont été passés aux rayons X. Ils ont été comparés aux spectres des produits de référence à savoir l'échantillon de nanotubes bruts (figure 6) et le carbure de silicium SiC (figure 7).

La figure 4 représente le spectre de l'échantillon -401 avec un ratio TMS/NTC=0.95 et la figure 5 représente le spectre de l'échantillon -402 avec un ratio TMS/NTC=2.19.

La figure 6 illustre le spectre de l'échantillon de NTC bruts de référence et met en évidence la raie de graphite que l'on retrouve sur les figures 4 et 5. La figure 7 illustre le spectre de l'échantillon de SiC.

Le SiC de référence, figure 7, est un produit en poudre de 2mm qui a été broyé pour les analyses aux rayons X, commercialisé par la Société VWR Prolabo.

On voit très clairement les raies fines sur le spectre du SiC figure 7 et on identifie les raies nettement du SiC sur l'échantillon avec un ratio égal à 2,19 représenté sur la figure 5.

Concernant l'échantillon avec le ratio égal à 0,95, les raies du SiC sont présentes mais moins franches.

Sur les deux échantillons figure 4 et figure 5, les raies SiC sont moins fines que pour l'échantillon de référence. L'organisation du cristal est donc moins parfaite.

Sur les deux échantillons illustrés par les figures 4 et 5, on retrouve également les raies du carbone graphite caractéristiques des nanotubes de carbone. Leur structure semble donc être conservée.

Les mesures aux rayons X montrent que :

Du carbure de silicium a bien été déposé sur les nanotubes.

Les pics sont plus marqués pour des grandes quantités de TMS injecté

Pour déterminer plus précisément la nature chimique du dépôt en surface, le déposant a utilisé une approche via l'ESCA (Electron Spectroscopy for Chemical Analysis) ou XPS (X Ray Photoelectron Spectroscopy).

Clairement, il a été démontré que le procédé de dépôt par CVD en lit fluidisé mis au point permet de réaliser un dépôt de silicium en quantité importante (jusqu'à 40% dans les essais). En outre, les rendements obtenus dépassent les 60%.

Le dépôt est constitué de SiC (carbure de silicium) et d'une couche oxydé sous forme SiOxCy. En outre le rapport SiC/ SiOxCy augmente avec le ratio précurseur injecté/NTC ce que confirment les résultats des analyses aux rayons X.

Le dépôt se fait sous forme de Si et le carbone du SiC provient des parois des nanotubes. L'hydrogène utilisé pour empêcher la déposition de carbone a pleinement rempli son rôle et aucun dépôt de carbone n'a été détecté.

De plus les analyses au microscope électronique ont montré que le dépôt réalisé est homogène entre les pelotes et à l'intérieur même d'une pelote.

Le déposant a également examiné le comportement vis-à-vis de la température et sous air des NTC recouverts de silicium selon le procédé.

Les Conditions opératoires ont été les suivantes:
Rampe de température: 5°C/min jusqu'à 900°C
Echantillon examiné (395) issu du premier essai.

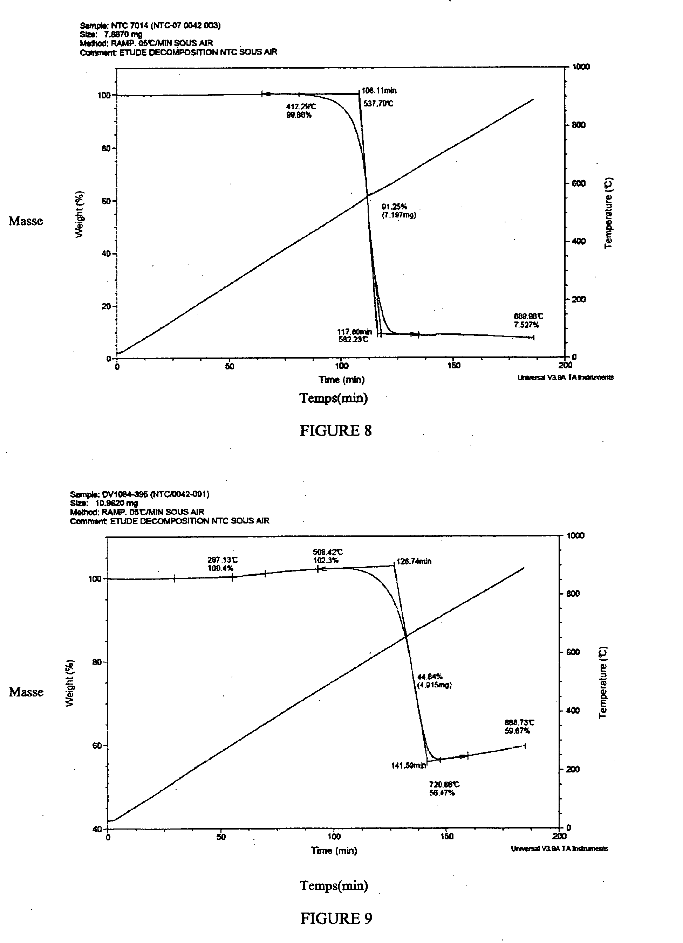

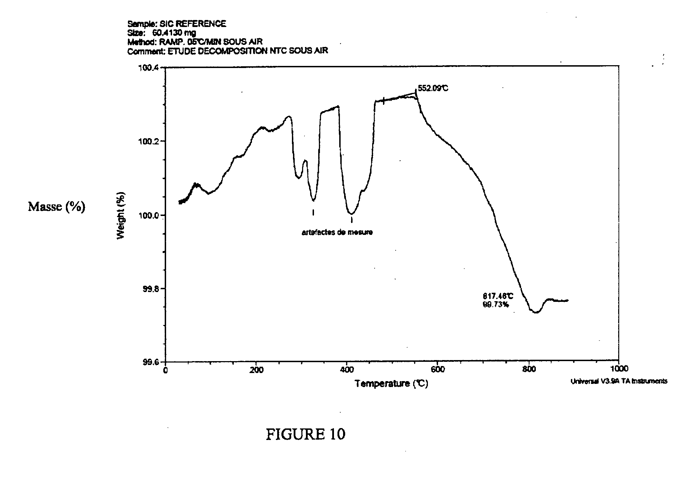

Les figures 8, 9 représentent respectivement les variations de la masse dans le temps, de l'échantillon de NTC bruts pris comme référence et de l'échantillon examiné 395 (essai 1), en fonction des variations de la température. Les conditions opératoires sont l'application d'une rampe de température de 5°C/min jusqu'à 900°C sous air comme l'illustre la droite sur les figures 8 et 9. La figure 10 représente la variation de la masse du SiC dans le temps en fonction de la variation de la température.

La décomposition des NTC est décalée à 644°C contre 538°C pour les NTC bruts (échantillon de référence) soit une amélioration de 20%.

La masse de l'échantillon 395 issu du premier essai augmente dès 290°C et surtout après 720°C ce qui correspond à l'oxydation du dépôt.

Par comparaison, le thermogramme du SiC représenté sur la figure 10, montre une légère augmentation de la masse de l'ordre de 0,4% avant 550°C. Ensuite la masse baisse brutalement avant de se stabiliser à 99.7% de sa masse initiale à une température de 817°C.

La prise de poids au début peut être imputable à la formation de SiO2 à partir du SiOxCy qui se trouve en surface. Le SiC, lui, n'est pas décomposé.

Si l'on revient à l'échantillon examiné, le gain de poids dès 290°C provient de l'oxydation du SiOxCy (formation en surface de SiO2).

Enfin l'augmentation du poids à haute température peut s'expliquer par l'oxydation de SiC.

La tenue en température pour l'échantillon examiné est améliorée de près de 20% et la décomposition en température est repoussée comme on peut le voir à partir des figures 8 et 9.

Le tableau ci-dessous permet d'illustrer, outre l'exemple d'un dépôt de Si sur des NTC dans les conditions de la présente invention, d'autres exemples de dépôt sur NTC avec des semi conducteurs comme le bore ou le germanium et de dépôt sur NTC avec des métaux comme l'aluminium, le cuivre et l'étain; les précurseurs choisis et les conditions de température et de pression.

| Métaux/semi conducteurs | Précurseur | Température °C | Pression |
|---|---|---|---|
| Si | TMS | 650<T<1000 | atmosphérique |
| B | Trimethyl boron (Tétraméthyl bore) Triethyl boron (Tetraéthyl bore) | 650 < T < 1000 | atmosphérique |
| Ge | Diéthylgermane, ( Diéthylgermanium) Tétraéthylgermane ( Tétraéthylgermanium) | 300 < T < 750 | atmosphérique |
| A1 (T_{fusion}= 660°) | Triméthyl aluminium | 300 < T < 750 | atmosphérique |
| Cu | Cu(II) acétylacétonate Cu(I)hexafluoroacétylacétonate 2-méthyl-1-hexène-3-yne | 300 < T < 750 | atmosphérique |
| Sn (T_{fusion}=231°) | Tetramethyl tin ( Tétraméthyl étain) | 400 < T < 750 | atmosphérique |

## Revendications

1. procédé de dépôt d'un métal ou métalloïde, sur des nanotubes de carbone (NTC), **caractérisé en ce qu'**il comprend:
- l'homogénéisation d'une poudre de NTC dans un réacteur,
- le dépôt sur cette poudre homogène de NTC dudit métal, choisi parmi l'étain, l'aluminium ou le cuivre, ou dudit métalloïde, choisi parmi le silicium, le bore, le germanium ; au moyen d'une technique de dépôt en phase vapeur opérée à l'intérieur du réacteur à partir d'un précurseur formé d'un alkyle de ce métal ou métalloïde ; le dépôt en phase vapeur est réalisé dans le réacteur à la pression atmosphérique et à une température inférieure à 1000°C, le précurseur étant injecté dans le réacteur, sous forme de gaz.

2. Procédé de dépôt selon la revendication 1, **caractérisé en ce que** la formation d'une poudre homogène de NTC est obtenue par la mise en lit fluidisé des NTC dans un réacteur en injectant un gaz dans ce réacteur.

3. Procédé de dépôt selon là revendication 2, **caractérisé en ce que** le précurseur à l'état liquide est transformé en phase vapeur par chauffage et injecté sous forme de gaz ou transporté au moyen d'un gaz de manière à être injecté sous forme de gaz.

4. Procédé de dépôt selon l'une quelconque des revendications 1. à 3, **caractérisé en ce** les NTC sont introduits à froid dans le réacteur, le gaz est injecté et balaye les NTC les mettant en lit fluidisé et formant ainsi une poudre homogène, le réacteur est mis en chauffe à une
température prédéfinie inférieure à 1000°C, lorsque la température prédéfinie est atteinte, le précurseur est injecté dans le réacteur et se décompose à la surface de NTC.

5. Procédé de dépôt selon la revendication 4, **caractérisé en ce que** le balayage est effectué avec un gaz inerte puis, lorsque la température prédéfinie est atteinte, le balayage avec le gaz inerte est arrêté et on injecte un deuxième gaz, ce gaz étant de l'hydrogène.

6. Procédé de dépôt selon l'une quelconque des revendications 1 à 5, **caractérisé en ce que** les NTC sont introduits dans le réacteur en quantité dosée pour une fabrication en lot ou en continu pour une fabrication continue.

7. Procédé de dépôt selon l'une quelconque des revendications 1 à 6, **caractérisé en ce qu'**il consiste à déposer du silicium et **en ce que** le précurseur est du tétraméthylsilane (TMS).

8. Procédé de dépôt selon la revendication 7, **caractérisé en ce que** le tétraméthylsilane (TMS) sous forme vapeur, est entrainé par un courant d'hydrogène afin de le diluer.

9. Procédé de dépôt selon l'une quelconque des revendications 1 à 6, **caractérisé en ce que** le dépôt est:
- du bore, le précurseur est du Trimethyl bore ou du Triethyl bore;
- du germanium, le précurseur est du Diethylgermanium ou du Tetraethylgermanium;
- de l'aluminium, le précurseur est du triméthyl aluminium
- du cuivre, le précurseur est de l'Acetylacetonate de Cu (II) ou de l'hexafluoroacetylacetonate 2-methyl-1-hexene-3-yne de Cu (I);
- de l'étain, le précurseur est du Tetramethyl étain.

10. application du procédé selon là revendication 7, à la fabrication de carbure de silicium nanostructure (SiC) à la surface des NTC.

11. Application du procède selon l'une quelconque des revendications 1 à 9 à la fabrication de matrices métalliques ou de céramiques composites.

## Claims

1. A process for depositing a metal or metalloid onto carbon nanotubes (CNTs), **characterized in that** it comprises:
- the homogenization of a CNT powder in a reactor,
- the deposition on this homogeneous CNT powder of said metal, chosen from tin, aluminum or copper, or of said metalloid, chosen from silicon, boron or germanium; by means of a vapor deposition technique carried out inside the reactor starting from a precursor formed from an alkyl of this metal or metalloid; the vapor deposition is carried out in the reactor at atmospheric pressure and at a temperature below 1000°C, the precursor being injected into the reactor in the form of gas.

2. The deposition process as claimed in claim 1, **characterized in that** the formation of a homogeneous CNT powder is obtained by placing the CNTs in a fluidized bed in a reactor while injecting a gas into this reactor.

3. The deposition process as claimed in claim 2, **characterized in that** the precursor in the liquid state is converted to the vapor phase by heating and injected in the form of gas or transported by means of a gas so as to be injected in the form of gas.

4. The deposition process as claimed in any one of claims 1 to 3, **characterized in that** the CNts are introduced cold into the reactor, the gas is injected and purges the CNTs, placing them in a fluidized bed and thus forming a homogeneous powder, the reactor is heated to a predefined temperature of less than 1000°C, when the predefined temperature is reached, the precursor is injected into the reactor and decomposes at the surface of the CNTs.

5. The deposition process at claimed in claim 4, **characterized in that** the purging is carried out with an inert gas, then, when the predefined temperature is reached, the purging with the inert gas is stopped and a second gas is injected, this gas being hydrogen.

6. The deposition process as claimed in any one of claims 1 to 5, **characterized in that** the CNTs are introduced into the reactor in a measured amount for batchwise production or continuously for continuous production.

7. The deposition process as claimed in any one of claims 1 to 6, **characterized in that** it consists in depositing silicon and **in that** the precursor is tetramethylsilane (TMS).

8. The deposition process as claimed in claim 7, **characterized in that** tetramethylsilane (TMS) in vapor form is conveyed by a stream of hydrogen in order to dilute it.

9. The deposition process as claimed in any one of claims 1 to 6, **characterized in that** the deposited material is:
- boron, the precursor is trimethylboron or triethylboron;
- germanium, the precursor is diethylgermanium or tetraethylgermanium;
- aluminum, the precursor is trimethylaluminum;
- copper, the precursor is copper (II) acetylacetonate or copper (I) hexafluoroacetylacetonate-2-methyl-2-hexen-3-yne;
- tin, the precursor is tetramethyltin.

10. The application of the process as claimed in claim 7 to the manufacture of nanostructured silicon carbide (SiC) at the surface of the CNTs.

11. The application of the process as claimed in any one of claims 1 to 9 to the manufacture of metal matrices or of composite ceramics.

## Patentansprüche

1. Verfahren zur Abscheidung eines Metalls oder Halbmetalls auf Kohlen stoff-Nanoröhren (CNT), **dadurch gekennzeichnet, dass** es umfasst:
- Homogenisieren eines CNT-Pulvers in einem Reaktor,
- Abscheiden des Metalls, das unter Zinn, Aluminium oder Kupfer ausgewählt ist, oder des Halbmetalls, das unter Silicium, Bor und Germanium ausgewählt ist, auf dem homogenen CNT-Pulver mit Hilfe einer Abscheidetechnik aus der Gasphase, die im Innern des Reaktor ausgehend von einem Vorläufer durchgeführt wird, der aus einer Alkylverbindung des Metalls oder Halbmetalls gebildet ist, wobei die Gasphasenabscheidung in dem Reaktor bei Atmosphärendruck und einer Temperatur unter 1000°C durchgeführt wird und der Vorläufer dem Reaktor in der Form eines Gases zugeführt wird.

2. Verfahren zur Abscheidung nach Anspruch 1, **dadurch gekennzeichnet, dass** das homogene CNT-Pulver gebildet wird, indem die CNT in einem Reaktor ins Fließbett gebracht werden, indem dem Reaktor ein Gas zugeführt wird.

3. Verfahren zur Abscheidung nach Anspruch 2, **dadurch gekennzeichnet, dass** der im flüssigen Zustand vorliegende Vorläufer durch Erwärmen in die Gasphase übergeführt und als Gas eingespeist wird oder durch ein Gas mitgeführt wird, sodass er alls Gas eingespeist wird.

4. Verfahren zur Abscheidung nach einem der Ansprüche 1 bis 3, **dadurch gekennzeichnet, dass** die CNT in der Kälte in den Reaktor gegeben, werden, das Gas eingespeist wird und die CNT spült, wobei die CNT ins Fließbett gebracht werden und auf diese Weise ein homogenes Pulver bilden, der Reaktor auf eine vorgegebene Temperatur unter 1000 °C erwärmt wird und der Vorläufer nach Erreichen, der vorgegebenen Temperatur in den Reaktor eingespeist wird und sich an der Oberfläche der CNT zersetzt.

5. Verfahren zur Abscheidung nach Anspruch 4, **dadurch gekennzeichnet, dass** das Spülen mit einem Inertgas durchgeführt wird, anschließend, sobald die vorgegebene Temperatur erreicht ist, das Spülen mit dem Inertgas abgebrochen wird und ein zweites Gas eingespeist wird, wobei es sich bei diesem Gas um Wasserstoff handelt.

6. Verfahren, zur Abscheidung nach einem der Ansprüche 1. bis 5, **dadurch gekennzeichnet, dass** die CNT für eine chargenweise Herstellung in einer vorgegebenen Menge oder für eine kontinuierliche Erzeugung kontinuierlich in den Reaktor eingebracht werden.

7. Verfahren, zur Abscheidung nach einem der Ansprüche 1 bis 6, **dadurch gekennzeichnet, dass** es darin besteht, Silicium abzuscheiden und **dadurch**, dass es sich bei dem Vorläufer um Tetramethyisilan (TMS) handelt.

8. Verfahren zur Abscheidung nach Anspruch 7, **dadurch gekennzeichnet, dass** das Tetramethylsilan (TMS) in Form von Dampf zu seiner Verdünnung von einem Wasserstoffstrom mit sich geführt wird.

9. Verfahren zur Abscheidung nach einem der Ansprüche 1 bis 6, **dadurch gekennzeichnet, dass** das Depot besteht aus:
- Bor und der Vorläufer Trimethylbor oder Triethylbor ist;
- Germanium und der Vorläufer Diethylgermanium oder Tetraethylgermanium ist;
- Aluminium und der Vorläufer Trimethylaluminium ist;
- Kupfer und der Vorläufer Cu(II)acetylacetonat oder Cu(I)-2-methyl-1-hexen-3-in-hexafluoracetylacetonat ist;
- Zinn und der Vorläufer Trimethyizinn ist.

10. Durchführung des Verfahrens nach Anspruch 7 zur Herstellung von nanostrukturiertem Siliciumcarbid (SiC) auf der CNT-Oberfläche.

11. Durchführung des Verfahrens nach einem der Ansprüche 1 bis 9 zur Herstellung von Metallmatrices oder Keramik-Verbundwerkstoffen.
